(19) Europäisches Patentamt / European Patent Office / Office européen des brevets

(11) **EP 3 121 812 B1**

(12) **EUROPEAN PATENT SPECIFICATION**

(45) Date of publication and mention of the grant of the patent:
**11.03.2020 Bulletin 2020/11**

(21) Application number: **15765124.1**

(22) Date of filing: **13.01.2015**

(51) Int Cl.:
*G10L 19/005* *(2013.01)*  *G10L 19/06* *(2013.01)*
*G10L 19/16* *(2013.01)*  *G10L 19/00* *(2013.01)*

(86) International application number:
**PCT/CN2015/070594**

(87) International publication number:
**WO 2015/139521 (24.09.2015 Gazette 2015/38)**

(54) **VOICE FREQUENCY CODE STREAM DECODING METHOD AND DEVICE**

VERFAHREN UND VORRICHTUNG ZUR DECODIERUNG VON SPRACHFREQUENZCODESTRÖMEN

PROCÉDÉ ET DISPOSITIF DE DÉCODAGE DE FLUX DE CODE DE FRÉQUENCE VOCALE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.03.2014 CN 201410108478**

(43) Date of publication of application:
**25.01.2017 Bulletin 2017/04**

(73) Proprietor: **Huawei Technologies Co., Ltd.**
**Longgang District**
**Shenzhen, Guangdong 518129 (CN)**

(72) Inventors:
 • **ZHANG, Xingtao**
 **Shenzhen**
 **Guangdong 518129 (CN)**
 • **LIU, Zexin**
 **Shenzhen**
 **Guangdong 518129 (CN)**
 • **MIAO, Lei**
 **Shenzhen**
 **Guangdong 518129 (CN)**

(74) Representative: **Kreuz, Georg Maria**
**Huawei Technologies Duesseldorf GmbH**
**Riesstraße 25**
**80992 München (DE)**

(56) References cited:
 WO-A1-00/63885  WO-A1-01/86637
 CN-A- 101 189 662  CN-A- 101 256 774
 CN-A- 101 894 558  US-A1- 2004 128 128

 • "Wideband coding of speech at around 16 kbit/s using Adaptive Multi-Rate Wideband (AMR-WB); G.722.2 Appendix 1 (01/02); Error concealment of erroneous or lost frames", ITU-T STANDARD IN FORCE (I), INTERNATIONAL TELECOMMUNICATION UNION, GENEVA, CH, no. G.722.2 Appendix 1 (, 13 January 2002 (2002-01-13), XP017400860,
 • "Wideband coding of speech at around 16 kbit/s using Adaptive Multi-Rate Wideband (AMR-WB); G.722.2 (07/03)", ITU-T STANDARD, INTERNATIONAL TELECOMMUNICATION UNION, GENEVA ; CH, no. G.722.2 (07/03), 29 July 2003 (2003-07-29), pages 1-72, XP017464096, [retrieved on 2004-09-06]
 • "Enhanced Variable Rate Codec, Speech Service Options 3, 68, 70, 73 and 77 for Wideband Spread Spectrum Digital Systems", 3GPP2 STANDARD; C.S0014-E, 3RD GENERATION PARTNERSHIP PROJECT 2, 3GPP2, 2500 WILSON BOULEVARD, SUITE 300, ARLINGTON, VIRGINIA 22201, USA, vol. TSGC, no. v1.0, 3 January 2012 (2012-01-03), pages 1-358, XP062013690, [retrieved on 2012-01-03]

## Description

### TECHNICAL FIELD

The present invention relates to audio decoding technologies, and specifically, to a speech/audio bitstream decoding method and apparatus.

### BACKGROUND

In a system based on Voice over Internet Protocol (VoIP, Voice over Internet Protocol), a packet may need to pass through multiple routers in a transmission process, but because these routers may change in a call process, a transmission delay in the call process may change. In addition, when two or more users attempt to enter a network by using a same gateway, a routing delay may change, and such a delay change is called a delay jitter (delay jitter). Similarly, a delay jitter may also be caused when a receiver, a transmitter, a gateway, and the like use a non-real-time operating system, and in a severe situation, a data packet loss occurs, resulting in speech/audio distortion and deterioration of VoIP quality.

Currently, many technologies have been used at different layers of a communication system to reduce a delay, smooth a delay jitter, and perform packet loss compensation. A receiver may use a high-efficiency jitter buffer processing (JBM, Jitter Buffer Management) algorithm to compensate for a network delay jitter to some extent. However, in a case of a relatively high packet loss rate, apparently, a high-quality communication requirement cannot be met only by using the JBM technology.

To help avoid the quality deterioration problem caused by a delay jitter of a speech/audio frame, a redundancy coding algorithm is introduced. That is, in addition to encoding current speech/audio frame information at a particular bit rate, an encoder encodes other speech/audio frame information than the current speech/audio frame at a lower bit rate, and transmits a relatively low bit rate bitstream of the other speech/audio frame information, as redundancy information, to a decoder together with a bitstream of the current speech/audio frame information. When a speech/audio frame is lost, if a jitter buffer buffers or a received bitstream includes redundancy information of the lost speech/audio frame, the decoder recovers the lost speech/audio frame according to the redundancy information, thereby improving speech/audio quality.

In an existing redundancy coding algorithm, in addition to including speech/audio frame information of the Nth frame, a bitstream of the Nth frame includes speech/audio frame information of the (N-M)th frame at lower bit rate. In a transmission process, if the (N-M)th frame is lost, decoding processing is performed according to the speech/audio frame information that is of the (N-M)th frame and is included in the bitstream of the Nth frame, to recover a speech/audio signal of the (N-M)th frame. "Wideband coding of speech at around 16kbit/s using Adaptive Multi-Rate Wideband (AMR-WB) Appendix I: Error concealment of erroneous or lost frames" describes a non-normative example solution for concealment of erroneous or lost frames for the G.722.2 AMR-WB codec. " Wideband coding of speech at around 16kbit/s using Adaptive Multi-Rate Wideband (AMR-WB)" describes the high quality Adaptive Multi-Rate Wideband (AMR-WB) encoder and decoder that is primarily intended for 7 kHz bandwidth speech signals.

Document WO 01/86637 A1 describes a method for recovering the LSF gain parameters in case of packet loss during the transmission of encoded audio data.

It can be learned from the foregoing description that, in the existing redundancy coding algorithm, redundancy bitstream information is obtained by means of encoding at a lower bit rate, which is therefore highly likely to cause signal instability and further cause low quality of an output speech/audio signal.

### SUMMARY

The present invention provides a speech/audio bitstream decoding method and apparatus, which help improve quality of an output speech/audio signal.

A first aspect of the present invention provides a speech/audio bitstream decoding method according to the features of the independent claims.

### BRIEF DESCRIPTION OF DRAWINGS

To describe the technical solutions of the present invention more clearly, in the following the accompanying drawings are briefly introduced describing embodiments of the present invention. Apparently, the accompanying drawings in the following description show merely some embodiments of the present invention.

FIG. 1 is a schematic flowchart of a speech/audio bitstream decoding method according to an embodiment of the present invention;
FIG. 2 is a schematic flowchart of another speech/audio bitstream decoding method according to an embodiment of the present invention;
FIG. 3 is a schematic diagram of a decoder according to an embodiment of the present invention;
FIG. 4 is a schematic diagram of another decoder according to an embodiment of the present invention; and
FIG. 5 is a schematic diagram of another decoder according to an embodiment of the present invention.

## DESCRIPTION OF EMBODIMENTS

The present invention provides a speech/audio bitstream decoding method and apparatus, which help improve quality of an output speech/audio signal.

To make the invention objectives, features, and advantages of the present invention clearer and more comprehensible, the following clearly describes the technical solutions of the present invention with reference to the accompanying drawings showing selected embodiments of the present invention. Apparently, the embodiments described in the following are merely a part rather than all of the embodiments of the present invention.

In the specification, claims, and accompanying drawings of the present invention, the terms "first", "second", "third", "fourth", and so on are intended to distinguish between different objects but not to indicate a particular order. In addition, the terms "including", "including", or any other variant thereof, are intended to cover a non-exclusive inclusion. For example, a process, a method, a system, a product, or a device including a series of steps or units is not limited to the listed steps or units, and may include steps or units that are not listed.

The following gives respective descriptions in details.

The speech/audio bitstream decoding method provided in the embodiments of the present invention is first described. The speech/audio bitstream decoding method provided in the embodiments of the present invention is executed by a decoder, where the decoder may be any apparatus that needs to output speeches, for example, a device such as a mobile phone, a notebook computer, a tablet computer, or a personal computer.

In an embodiment of the speech/audio bitstream decoding method in the present invention, the speech/audio bitstream decoding method may include: acquiring a speech/audio decoding parameter of a current speech/audio frame, where the foregoing current speech/audio frame is a redundant decoded frame or a speech/audio frame previous to the foregoing current speech/audio frame is a redundant decoded frame; performing post processing on the speech/audio decoding parameter of the foregoing current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame, and M and N are positive integers; and recovering a speech/audio signal of the foregoing current speech/audio frame by using the post-processed speech/audio decoding parameter of the foregoing current speech/audio frame.

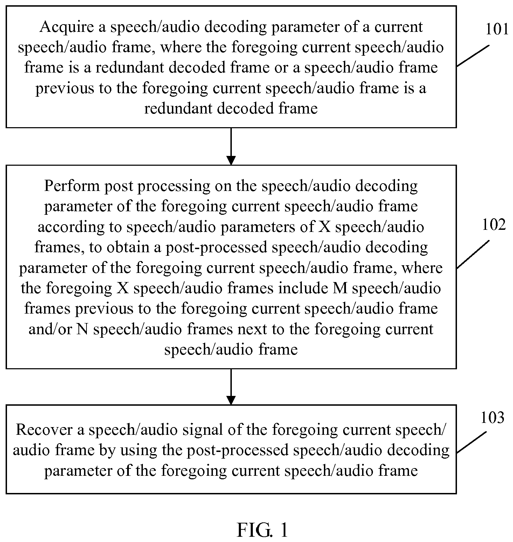

FIG. 1 is a schematic flowchart of a speech/audio bitstream decoding method according to an embodiment of the present invention. The speech/audio bitstream decoding method provided in this embodiment of the present invention may include the following content:

101. Acquire a speech/audio decoding parameter of a current speech/audio frame.

The foregoing current speech/audio frame is a redundant decoded frame or a speech/audio frame previous to the foregoing current speech/audio frame is a redundant decoded frame.

When the speech/audio frame previous to the foregoing current speech/audio frame is a redundant decoded frame, the current speech/audio frame may be a normal decoded frame, an FEC recovered frame, or a redundant decoded frame, where if the current speech/audio frame is an FEC recovered frame, the speech/audio decoding parameter of the current speech/audio frame may be predicated based on an FEC algorithm.

102. Perform post processing on the speech/audio decoding parameter of the foregoing current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame, and M and N are positive integers.

That a speech/audio frame (for example, the current speech/audio frame or the speech/audio frame previous to the current speech/audio frame) is a normal decoded frame means that a speech/audio parameter of the foregoing speech/audio frame can be directly obtained from a bitstream of the speech/audio frame by means of decoding. That a speech/audio frame (for example, a current speech/audio frame or a speech/audio frame previous to a current speech/audio frame) is a redundant decoded frame means that a speech/audio parameter of the speech/audio frame cannot be directly obtained from a bitstream of the speech/audio frame by means of decoding, but redundant bitstream information of the speech/audio frame can be obtained from a bitstream of another speech/audio frame.

The M speech/audio frames previous to the current speech/audio frame refer to M speech/audio frames preceding the current speech/audio frame and immediately adjacent to the current speech/audio frame in a time domain.

For example, M may be equal to 1, 2, 3, or another value. When M=1, the M speech/audio frames previous to the current speech/audio frame are the speech/audio frame previous to the current speech/audio frame, and the speech/audio frame previous to the current speech/audio frame and the current speech/audio frame are two immediately adjacent speech/audio frames; when M=2, the M speech/audio frames previous to the current speech/audio frame are the speech/audio frame previous to the current speech/audio frame and a speech/audio frame previous to the speech/audio frame previous to the current speech/audio frame, and the speech/audio frame previous to the current speech/audio frame, the speech/audio frame previous to the speech/audio frame previous to the current speech/audio frame, and the current speech/audio frame are three immediately adjacent speech/audio frames; and so on.

The N speech/audio frames next to the current speech/audio frame refer to N speech/audio frames following the current speech/audio frame and immediately adjacent to the current speech/audio frame in a time domain.

For example, N may be equal to 1, 2, 3, 4, or another value. When N=1, the N speech/audio frames next to the current speech/audio frame are a speech/audio frame next to the current speech/audio frame, and the speech/audio frame next to the current speech/audio frame and the current speech/audio frame are two immediately adjacent speech/audio frames; when N=2, the N speech/audio frames next to the current speech/audio frame are a speech/audio frame next to the current speech/audio frame and a speech/audio frame next to the speech/audio frame next to the current speech/audio frame, and the speech/audio frame next to the current speech/audio frame, the speech/audio frame next to the speech/audio frame next to the current speech/audio frame, and the current speech/audio frame are three immediately adjacent speech/audio frames; and so on.

The speech/audio decoding parameter may include at least one of the following parameters:
a bandwidth extension envelope, an adaptive codebook gain (gain_pit), an algebraic codebook, a pitch period, a spectrum tilt factor, a spectral pair parameter, and the like.

The speech/audio parameter may include a speech/audio decoding parameter, a signal class, and the like.

A signal class of a speech/audio frame may be unvoiced (UNVOICED), voiced (VOICED), generic (GENERIC), transient (TRANSIENT), inactive (INACTIVE), or the like.

The spectral pair parameter may be, for example, at least one of a line spectral pair (LSP: Line Spectral Pair) parameter or an immittance spectral pair (ISP: Immittance Spectral Pair) parameter.

It may be understood that in this embodiment of the present invention, post processing may be performed on at least one speech/audio decoding parameter of a bandwidth extension envelope, an adaptive codebook gain, an algebraic codebook, a pitch period, or a spectral pair parameter of the current speech/audio frame. Specifically, how many parameters are selected and which parameters are selected for post processing may be determined according to an application scenario and an application environment, which is not limited in this embodiment of the present invention.

Different post processing may be performed on different speech/audio decoding parameters. For example, post processing performed on the spectral pair parameter of the current speech/audio frame may be adaptive weighting performed by using the spectral pair parameter of the current speech/audio frame and a spectral pair parameter of the speech/audio frame previous to the current speech/audio frame, to obtain a post-processed spectral pair parameter of the current speech/audio frame, and post processing performed on the adaptive codebook gain of the current speech/audio frame may be adjustment such as attenuation performed on the adaptive codebook gain.

A specific post processing manner is not limited in this embodiment of the present invention, and specific post processing may be set according to a requirement or according to an application environment and an application scenario.

103. Recover a speech/audio signal of the foregoing current speech/audio frame by using the post-processed speech/audio decoding parameter of the foregoing current speech/audio frame.

It can be learned from the foregoing description that in this embodiment, in a scenario in which a current speech/audio frame is a redundant decoded frame or a speech/audio frame previous to the foregoing current speech/audio frame is a redundant decoded frame, after obtaining a speech/audio decoding parameter of the current speech/audio frame, a decoder performs post processing on the speech/audio decoding parameter of the current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame, and recovers a speech/audio signal of the current speech/audio frame by using the post-processed speech/audio decoding parameter of the current speech/audio frame, which ensures stable quality of a decoded signal during transition between a redundant decoded frame and a normal decoded frame or between a redundant decoded frame and an FEC recovered frame, thereby improving quality of an output speech/audio signal.

In some embodiments of the present invention, the speech/audio decoding parameter of the foregoing current speech/audio frame includes the spectral pair parameter of the foregoing current speech/audio frame, and the performing post processing on the speech/audio decoding parameter of the foregoing current speech/audio frame according to speech/audio parameters of X speech/audio frames, to obtain a post-processed speech/audio decoding parameter of the foregoing current speech/audio frame, for example, may include: performing post processing on the spectral pair parameter of the foregoing current speech/audio frame according to at least one of a signal class, a spectrum tilt factor, an adaptive codebook gain, or a spectral pair parameter of the X speech/audio frames, to obtain a post-processed spectral pair parameter of the foregoing current speech/audio frame.

For example, the performing post processing on the spectral pair parameter of the foregoing current speech/audio frame according to at least one of a signal class, a spectrum tilt factor, an adaptive codebook gain, or a spectral pair parameter of the X speech/audio frames, to obtain a post-processed spectral pair parameter of the foregoing current speech/audio frame may include:

if the foregoing current speech/audio frame is a normal decoded frame, the speech/audio frame previous to the foregoing current speech/audio frame is a redundant decoded frame, a signal class of the foregoing current speech/audio frame is unvoiced, and a signal class of the speech/audio frame previous to the foregoing current speech/audio frame is not unvoiced, using the spectral pair parameter of the foregoing current speech/audio frame as the post-processed spectral pair parameter of the foregoing current speech/audio frame, or obtaining the post-processed spectral pair parameter of the foregoing current speech/audio frame based on the spectral pair parameter of the foregoing current speech/audio frame; or

if the foregoing current speech/audio frame is a normal decoded frame, the speech/audio frame previous to the foregoing current speech/audio frame is a redundant decoded frame, a signal class of the foregoing current speech/audio frame is unvoiced, and a signal class of the speech/audio frame previous to the foregoing current speech/audio frame is not unvoiced, obtaining the post-processed spectral pair parameter of the foregoing current speech/audio frame based on the spectral pair parameter of the current speech/audio frame and a spectral pair parameter of the speech/audio frame previous to the foregoing current speech/audio frame; or

if the foregoing current speech/audio frame is a redundant decoded frame, a signal class of the foregoing current speech/audio frame is not unvoiced, and a signal class of a speech/audio frame next to the foregoing current speech/audio frame is unvoiced, using a spectral pair parameter of the speech/audio frame previous to the foregoing current speech/audio frame as the post-processed spectral pair parameter of the foregoing current speech/audio frame, or obtaining the post-processed spectral pair parameter of the foregoing current speech/audio frame based on a spectral pair parameter of the speech/audio frame previous to the foregoing current speech/audio frame; or

if the foregoing current speech/audio frame is a redundant decoded frame, a signal class of the foregoing current speech/audio frame is not unvoiced, and a signal class of a speech/audio frame next to the foregoing current speech/audio frame is unvoiced, obtaining the post-processed spectral pair parameter of the foregoing current speech/audio frame based on the spectral pair parameter of the foregoing current speech/audio frame and a spectral pair parameter of the speech/audio frame previous to the foregoing current speech/audio frame; or

if the foregoing current speech/audio frame is a redundant decoded frame, a signal class of the foregoing current speech/audio frame is not unvoiced, a maximum value of an adaptive codebook gain of a subframe in a speech/audio frame next to the foregoing current speech/audio frame is less than or equal to a first threshold, and a spectrum tilt factor of the speech/audio frame previous to the foregoing current speech/audio frame is less than or equal to a second threshold, using a spectral pair parameter of the speech/audio frame previous to the foregoing current speech/audio frame as the post-processed spectral pair parameter of the foregoing current speech/audio frame, or obtaining the post-processed spectral pair parameter of the foregoing current speech/audio frame based on a spectral pair parameter of the speech/audio frame previous to the foregoing current speech/audio frame; or

if the foregoing current speech/audio frame is a redundant decoded frame, a signal class of the foregoing current speech/audio frame is not unvoiced, a maximum value of an adaptive codebook gain of a subframe in a speech/audio frame next to the foregoing current speech/audio frame is less than or equal to a first threshold, and a spectrum tilt factor of the speech/audio frame previous to the foregoing current speech/audio frame is less than or equal to a second threshold, obtaining the post-processed spectral pair parameter of the foregoing current speech/audio frame based on the spectral pair parameter of the current speech/audio frame and a spectral pair parameter of the speech/audio frame previous to the foregoing current speech/audio frame; or

if the foregoing current speech/audio frame is a redundant decoded frame, a signal class of the foregoing current speech/audio frame is not unvoiced, a speech/audio frame next to the foregoing current speech/audio frame is unvoiced, a maximum value of an adaptive codebook gain of a subframe in the speech/audio frame next to the foregoing current speech/audio frame is less than or equal to a third threshold, and a spectrum tilt factor of the speech/audio frame previous to the foregoing current speech/audio frame is less than or equal to a fourth threshold, using a spectral pair parameter of the speech/audio frame previous to the foregoing current speech/audio frame as the post-processed spectral pair parameter of the foregoing current speech/audio frame, or obtaining the post-processed spectral pair parameter of the foregoing current speech/audio frame based on a spectral pair parameter of the speech/audio frame previous to the foregoing current speech/audio frame; or

if the foregoing current speech/audio frame is a redundant decoded frame, a signal class of the foregoing current speech/audio frame is not unvoiced, a signal class of a speech/audio frame next to the foregoing current speech/audio frame is unvoiced, a maximum value of an adaptive codebook gain of a subframe in the speech/audio frame next to the foregoing current speech/audio frame is less than or equal to a third threshold, and a spectrum tilt factor of the speech/audio frame previous to the foregoing current speech/audio frame is less than or equal to a fourth threshold, obtaining the post-processed spectral pair parameter of the foregoing current speech/audio frame based on the spectral pair parameter of the foregoing current speech/audio frame and a spectral pair parameter of the speech/audio frame previous to the foregoing current speech/audio frame.

There may be various manners for obtaining the post-processed spectral pair parameter of the foregoing current speech/audio frame based on the spectral pair parameter of the foregoing current speech/audio frame and a spectral pair parameter of the speech/audio frame previous to the foregoing current speech/audio frame.

For example, the obtaining the post-processed spectral pair parameter of the foregoing current speech/audio frame based on the spectral pair parameter of the foregoing current speech/audio frame and a spectral pair parameter of the speech/audio frame previous to the foregoing current speech/audio frame may include: specifically obtaining the post-processed spectral pair parameter of the foregoing current speech/audio frame based on the spectral pair parameter of the foregoing current speech/audio frame and the spectral pair parameter of the speech/audio frame previous to the foregoing current speech/audio frame and by using the following formula:

$$lsp[k] = \alpha * lsp\_old[k] + \beta * lsp\_mid[k] + \delta * lsp\_new[k] \quad 0 \le k \le L$$,

where

$lsp[k]$ is the post-processed spectral pair parameter of the foregoing current speech/audio frame, $lsp\_old[k]$ is the spectral pair parameter of the speech/audio frame previous to the foregoing current speech/audio frame, $lsp\_mid[k]$ is a middle value of the spectral pair parameter of the foregoing current speech/audio frame, $lsp\_new[k]$ is the spectral pair parameter of the foregoing current speech/audio frame, L is an order of a spectral pair parameter, $\alpha$ is a weight of the spectral pair parameter of the speech/audio frame previous to the foregoing current speech/audio frame, $\beta$ is a weight of the middle value of the spectral pair parameter of the foregoing current speech/audio frame, $\delta$ is a weight of the spectral pair parameter of the foregoing current speech/audio frame, $\alpha \ge 0$, $\beta \ge 0$, $\delta \ge 0$, and $\alpha + \beta + \delta = 1$, where

if the foregoing current speech/audio frame is a normal decoded frame, and the speech/audio frame previous to the foregoing current speech/audio frame is a redundant decoded frame, $\alpha$ is equal to 0 or $\alpha$ is less than or equal to a fifth threshold; or if the foregoing current speech/audio frame is a redundant decoded frame, $\beta$ is equal to 0 or $\beta$ is less than or equal to a sixth threshold; or if the foregoing current speech/audio frame is a redundant decoded frame, $\delta$ is equal to 0 or $\delta$ is less than or equal to a seventh threshold; or if the foregoing current speech/audio frame is a redundant decoded frame, $\beta$ is equal to 0 or $\beta$ is less than or equal to a sixth threshold, and $\delta$ is equal to 0 or $\delta$ is less than or equal to a seventh threshold.

For another example, the obtaining the post-processed spectral pair parameter of the foregoing current speech/audio frame based on the spectral pair parameter of the foregoing current speech/audio frame and a spectral pair parameter of the speech/audio frame previous to the foregoing current speech/audio frame may include: specifically obtaining the post-processed spectral pair parameter of the foregoing current speech/audio frame based on the spectral pair parameter of the foregoing current speech/audio frame and the spectral pair parameter of the speech/audio frame previous to the foregoing current speech/audio frame and by using the following formula:

$$lsp[k] = \alpha * lsp\_old[k] + \delta * lsp\_new[k] \quad 0 \le k \le L$$,

where

$lsp[k]$ is the post-processed spectral pair parameter of the foregoing current speech/audio frame, $lsp\_old[k]$ is the spectral pair parameter of the speech/audio frame previous to the foregoing current speech/audio frame, $lsp\_new[k]$ is the spectral pair parameter of the foregoing current speech/audio frame, L is an order of a spectral pair parameter, $\alpha$ is a weight of the spectral pair parameter of the speech/audio frame previous to the foregoing current speech/audio frame, $\delta$ is a weight of the spectral pair parameter of the foregoing current speech/audio frame, $\alpha \ge 0$, $\delta \ge 0$, and $\alpha + \delta = 1$, where

if the foregoing current speech/audio frame is a normal decoded frame, and the speech/audio frame previous to the foregoing current speech/audio frame is a redundant decoded frame, $\alpha$ is equal to 0 or $\alpha$ is less than or equal to a fifth threshold; or if the foregoing current speech/audio frame is a redundant decoded frame, $\delta$ is equal to 0 or $\delta$ is less than or equal to a seventh threshold.

The fifth threshold, the sixth threshold, and the seventh threshold each may be set to different values according to different application environments or scenarios. For example, a value of the fifth threshold may be close to 0, where for example, the fifth threshold may be equal to 0.001, 0.002, 0.01, 0.1, or another value close to 0; a value of the sixth threshold may be close to 0, where for example, the sixth threshold may be equal to 0.001, 0.002, 0.01, 0.1, or another value close to 0; and a value of the seventh threshold may be close to 0, where for example, the seventh threshold may be equal to 0.001, 0.002, 0.01, 0.1, or another value close to 0.

The first threshold, the second threshold, the third threshold, and the fourth threshold each may be set to different values according to different application environments or scenarios.

For example, the first threshold may be set to 0.9, 0.8, 0.85, 0.7, 0.89, or 0.91.

For example, the second threshold may be set to 0.16, 0.15, 0.165, 0.1, 0.161, or 0.159.

For example, the third threshold may be set to 0.9, 0.8, 0.85, 0.7, 0.89, or 0.91.

For example, the fourth threshold may be set to 0.16, 0.15, 0.165, 0.1, 0.161, or 0.159.

The first threshold may be equal to or not equal to the third threshold, and the second threshold may be equal to or not equal to the fourth threshold.

In other embodiments of the present invention, the speech/audio decoding parameter of the foregoing current speech/audio frame includes the adaptive codebook gain of the foregoing current speech/audio frame, and the performing post processing on the speech/audio decoding parameter of the foregoing current speech/audio frame according to speech/audio parameters of X speech/audio frames, to obtain a post-processed speech/audio decoding parameter of the foregoing current speech/audio frame may include: performing post processing on the adaptive codebook gain of the foregoing current speech/audio frame according to at least one of the signal class, an algebraic codebook gain, or the adaptive codebook gain of the X speech/audio frames, to obtain a post-processed adaptive codebook gain of the foregoing current speech/audio frame.

For example, the performing post processing on the adaptive codebook gain of the foregoing current speech/audio frame according to at least one of the signal class, an algebraic codebook gain, or the adaptive codebook gain of the X speech/audio frames may include:

if the foregoing current speech/audio frame is a redundant decoded frame, the signal class of the foregoing current speech/audio frame is not unvoiced, a signal class of at least one of two speech/audio frames next to the foregoing current speech/audio frame is unvoiced, and an algebraic codebook gain of a current subframe of the foregoing current speech/audio frame is greater than or equal to an algebraic codebook gain of the speech/audio frame previous to the foregoing current speech/audio frame (for example, the algebraic codebook gain of the current subframe of the foregoing current speech/audio frame is 1 or more than 1 time, for example, 1, 1.5, 2, 2.5, 3, 3.4, or 4 times, the algebraic codebook gain of the speech/audio frame previous to the foregoing current speech/audio frame, attenuating an adaptive codebook gain of the foregoing current subframe; or

if the foregoing current speech/audio frame is a redundant decoded frame, the signal class of the foregoing current speech/audio frame is not unvoiced, a signal class of at least one of the speech/audio frame next to the foregoing current speech/audio frame or a speech/audio frame next to the next speech/audio frame is unvoiced, and an algebraic codebook gain of a current subframe of the foregoing current speech/audio frame is greater than or equal to an algebraic codebook gain of a subframe previous to the foregoing current subframe (for example, the algebraic codebook gain of the current subframe of the foregoing current speech/audio frame is 1 or more than 1 time, for example, 1, 1.5, 2, 2.5, 3, 3.4, or 4 times, the algebraic codebook gain of the subframe previous to the foregoing current subframe), attenuating an adaptive codebook gain of the foregoing current subframe; or

if the foregoing current speech/audio frame is a redundant decoded frame, or the foregoing current speech/audio frame is a normal decoded frame, and the speech/audio frame previous to the foregoing current speech/audio frame is a redundant decoded frame, and if the signal class of the foregoing current speech/audio frame is generic, the signal class of the speech/audio frame next to the foregoing current speech/audio frame is voiced, and an algebraic codebook gain of a subframe of the foregoing current speech/audio frame is greater than or equal to an algebraic codebook gain of a subframe previous to the foregoing subframe (for example, the algebraic codebook gain of the subframe of the foregoing current speech/audio frame may be 1 or more than 1 time, for example, 1, 1.5, 2, 2.5, 3, 3.4, or 4 times, the algebraic codebook gain of the subframe previous to the foregoing subframe), adjusting (for example, augmenting or attenuating) an adaptive codebook gain of a current subframe of the foregoing current speech/audio frame based on at least one of a ratio of an algebraic codebook gain of the current subframe of the foregoing current speech/audio frame to that of a subframe adjacent to the foregoing current subframe, a ratio of the adaptive codebook gain of the current subframe of the foregoing current speech/audio frame to that of the subframe adjacent to the foregoing current subframe, or a ratio of the algebraic codebook gain of the current subframe of the foregoing current speech/audio frame to that of the speech/audio frame previous to the foregoing current speech/audio frame (for example, if the ratio of the algebraic codebook gain of the current subframe of the foregoing current speech/audio frame to that of the subframe adjacent to the foregoing current subframe is greater than or equal to an eleventh threshold (where the eleventh threshold may be equal to, for example, 2, 2.1, 2.5, 3, or another value), the ratio of the adaptive codebook gain of the current subframe of the foregoing current speech/audio frame to that of the subframe adjacent to the foregoing current subframe is greater than or equal to a twelfth threshold (where the twelfth threshold may be equal to, for example, 1, 1.1, 1.5, 2, 2.1, or another value), and the ratio of the algebraic codebook gain of the current subframe of the foregoing current speech/audio frame to that of the speech/audio frame previous to the foregoing current speech/audio frame is less than or equal to a thirteenth threshold (where the thirteenth threshold may be equal to, for example, 1, 1.1, 1.5, 2, or another value), the adaptive codebook gain of the current subframe of the foregoing current speech/audio frame may be augmented); or

if the foregoing current speech/audio frame is a redundant decoded frame, or the foregoing current speech/audio frame is a normal decoded frame, and the speech/audio frame previous to the foregoing current speech/audio frame is a redundant decoded frame, and if the signal class of the foregoing current speech/audio frame is generic, the signal class of the speech/audio frame next to the foregoing current speech/audio frame is voiced, and an algebraic codebook gain of a subframe of the foregoing current speech/audio frame is greater than or equal to an algebraic codebook gain of the speech/audio frame previous to the foregoing current speech/audio frame (where the algebraic codebook gain of the subframe of the foregoing current speech/audio frame is 1 or more than 1 time, for example, 1, 1.5, 2, 2.5, 3, 3.4, or 4 times, the algebraic codebook gain of the speech/audio frame previous to the foregoing current speech/audio frame), adjusting (attenuating or augmenting) an adaptive codebook gain of a current subframe of the foregoing current speech/audio frame based on at least one of a ratio of an algebraic codebook gain of the current subframe of the foregoing current speech/audio frame to that of a subframe adjacent to the foregoing current subframe, a ratio of the adaptive codebook gain of the current subframe of the foregoing current speech/audio frame to that of the subframe adjacent to the foregoing current subframe, or a ratio of the algebraic codebook gain of the current subframe of the foregoing current speech/audio frame to that of the speech/audio frame previous to the foregoing current speech/audio frame (for example, if the ratio of the algebraic codebook gain of the current subframe of the foregoing current speech/audio frame to that of the subframe adjacent to the foregoing current subframe is greater than or equal to an eleventh threshold (where the eleventh threshold may be equal to, for example, 2, 2.1, 2.5, 3, or another value), the ratio of the adaptive codebook gain of the current subframe of the foregoing current speech/audio frame to that of the subframe adjacent to the foregoing current subframe is greater than or equal to a twelfth threshold (where the twelfth threshold may be equal to, for example, 1, 1.1, 1.5, 2, 2.1, or another value), and the ratio of the algebraic codebook gain of the current subframe of the foregoing current speech/audio frame to that of the speech/audio frame previous to the foregoing current speech/audio frame is less than or equal to a thirteenth threshold (where the thirteenth threshold may be equal to, for example, 1, 1.1, 1.5, 2, or another value), the adaptive codebook gain of the current subframe of the foregoing current speech/audio frame may be augmented); or

if the foregoing current speech/audio frame is a redundant decoded frame, or the foregoing current speech/audio frame is a normal decoded frame, and the speech/audio frame previous to the foregoing current speech/audio frame is a redundant decoded frame, and if the foregoing current speech/audio frame is voiced, the signal class of the speech/audio frame previous to the foregoing current speech/audio frame is generic, and an algebraic codebook gain of a subframe of the foregoing current speech/audio frame is greater than or equal to an algebraic codebook gain of a subframe previous to the foregoing subframe (for example, the algebraic codebook gain of the subframe of the foregoing current speech/audio frame may be 1 or more than 1 time, for example, 1, 1.5, 2, 2.5, 3, 3.4, or 4 times, the algebraic codebook gain of the subframe previous to the foregoing subframe), adjusting (attenuating or augmenting) an adaptive codebook gain of a current subframe of the foregoing current speech/audio frame based on at least one of a ratio of an algebraic codebook gain of the current subframe of the foregoing current speech/audio frame to that of a subframe adjacent to the foregoing current subframe, a ratio of the adaptive codebook gain of the current subframe of the foregoing current speech/audio frame to that of the subframe adjacent to the foregoing current subframe, or a ratio of the algebraic codebook gain of the current subframe of the foregoing current speech/audio frame to that of the speech/audio frame previous to the foregoing current speech/audio frame (for example, if the ratio of the algebraic codebook gain of the current subframe of the foregoing current speech/audio frame to that of the subframe adjacent to the foregoing current subframe is greater than or equal to an eleventh threshold (where the eleventh threshold is equal to, for example, 2, 2.1, 2.5, 3, or another value), the ratio of the adaptive codebook gain of the current subframe of the foregoing current speech/audio frame to that of the subframe adjacent to the foregoing current subframe is greater than or equal to a twelfth threshold (where the twelfth threshold is equal to, for example, 1, 1.1, 1.5, 2, 2.1, or another value), and the ratio of the algebraic codebook gain of the current subframe of the foregoing current speech/audio frame to that of the speech/audio frame previous to the foregoing current speech/audio frame is less than or equal to a thirteenth threshold (where the thirteenth threshold may be equal to, for example, 1, 1.1, 1.5, 2, or another value), the adaptive codebook gain of the current subframe of the foregoing current speech/audio frame may be augmented; or

if the foregoing current speech/audio frame is a redundant decoded frame, or the foregoing current speech/audio frame is a normal decoded frame, and the speech/audio frame previous to the foregoing current speech/audio frame is a redundant decoded frame, and if the signal class of the foregoing current speech/audio frame is voiced, the signal class of the speech/audio frame previous to the foregoing current speech/audio frame is generic, and an algebraic codebook gain of a subframe of the foregoing current speech/audio frame is greater than or equal to an algebraic codebook gain of the speech/audio frame previous to the foregoing current speech/audio frame (for example, the algebraic codebook gain of the subframe of the foregoing current speech/audio frame is 1 or more than 1 time, for example, 1, 1.5, 2, 2.5, 3, 3.4, or 4 times, the algebraic codebook gain of the speech/audio frame previous to the foregoing current speech/audio frame), adjusting (attenuating or augmenting) an adaptive codebook gain of a current subframe of the foregoing current speech/audio frame based on at least one of a ratio of an algebraic codebook gain of the current subframe of the foregoing current speech/audio frame to that of a subframe adjacent to the foregoing current subframe, a ratio of the adaptive codebook gain of the current subframe of the foregoing current speech/audio frame to that of the subframe adjacent to the foregoing current subframe, or a ratio of the algebraic codebook gain of the current subframe of the foregoing current speech/audio frame to that of the speech/audio frame previous to the foregoing current speech/audio frame (for example, if the ratio of the algebraic codebook gain of the current subframe of the foregoing current speech/audio frame to that of the subframe adjacent to the foregoing current subframe is greater than or equal to an eleventh threshold (where the eleventh threshold may be equal to, for example, 2, 2.1, 2.5, 3, or another value), the ratio of the adaptive codebook gain of the current subframe of the foregoing current speech/audio frame to that of the subframe adjacent to the foregoing current subframe is greater than or equal to a twelfth threshold (where the twelfth threshold may be equal to, for example, 1, 1.1, 1.5, 2, 2.1, or another value), and the ratio of the algebraic codebook gain of the current subframe of the foregoing current speech/audio frame to that of the speech/audio frame previous to the foregoing current speech/audio frame is less than or equal to a thirteenth threshold (where the thirteenth threshold is equal to, for example, 1, 1.1, 1.5, 2, or another value), the adaptive codebook gain of the current subframe of the foregoing current speech/audio frame may be augmented.

In other embodiments of the present invention, the speech/audio decoding parameter of the foregoing current speech/audio frame includes the algebraic codebook of the foregoing current speech/audio frame, and the performing post processing on the speech/audio decoding parameter of the foregoing current speech/audio frame according to speech/audio parameters of X speech/audio frames, to obtain a post-processed speech/audio decoding parameter of the foregoing current speech/audio frame may include: performing post processing on the algebraic codebook of the foregoing current speech/audio frame according to at least one of the signal class, an algebraic codebook, or the spectrum tilt factor of the X speech/audio frames, to obtain a post-processed algebraic codebook of the foregoing current speech/audio frame.

For example, the performing post processing on the algebraic codebook of the foregoing current speech/audio frame according to at least one of the signal class, an algebraic codebook, or the spectrum tilt factor of the X speech/audio frames may include: if the foregoing current speech/audio frame is a redundant decoded frame, the signal class of the speech/audio frame next to the foregoing current speech/audio frame is unvoiced, the spectrum tilt factor of the speech/audio frame previous to the foregoing current speech/audio frame is less than or equal to an eighth threshold, and an algebraic codebook of a subframe of the foregoing current speech/audio frame is 0 or is less than or equal to a ninth threshold, using an algebraic codebook or a random noise of a subframe previous to the foregoing current speech/audio frame as an algebraic codebook of the foregoing current subframe.

The eighth threshold and the ninth threshold each may be set to different values according to different application environments or scenarios.

For example, the eighth threshold may be set to 0.16, 0.15, 0.165, 0.1, 0.161, or 0.159.

For example, the ninth threshold may be set to 0.1, 0.09, 0.11, 0.07, 0.101, 0.099, or another value close to 0.

The eighth threshold may be equal to or not equal to the second threshold.

In other embodiments of the present invention, the speech/audio decoding parameter of the foregoing current speech/audio frame includes a bandwidth extension envelope of the foregoing current speech/audio frame, and the performing post processing on the speech/audio decoding parameter of the foregoing current speech/audio frame according to speech/audio parameters of X speech/audio frames, to obtain a post-processed speech/audio decoding parameter of the foregoing current speech/audio frame may include: performing post processing on the bandwidth extension envelope of the foregoing current speech/audio frame according to at least one of the signal class, a bandwidth extension envelope, or the spectrum tilt factor of the X speech/audio frames, to obtain a post-processed bandwidth extension envelope of the foregoing current speech/audio frame.

For example, the performing post processing on the bandwidth extension envelope of the foregoing current speech/audio frame according to at least one of the signal class, a bandwidth extension envelope, or the spectrum tilt factor of the X speech/audio frames, to obtain a post-processed bandwidth extension envelope of the foregoing current speech/audio frame may include:

if the speech/audio frame previous to the foregoing current speech/audio frame is a normal decoded frame, and the signal class of the speech/audio frame previous to the foregoing current speech/audio frame is the same as that of the speech/audio frame next to the current speech/audio frame, obtaining the post-processed bandwidth extension envelope of the foregoing current speech/audio frame based on a bandwidth extension envelope of the speech/audio frame previous to the foregoing current speech/audio frame and the bandwidth extension envelope of the foregoing current speech/audio frame; or
if the foregoing current speech/audio frame is a prediction form of redundancy decoding, obtaining the post-processed bandwidth extension envelope of the foregoing current speech/audio frame based on a bandwidth extension envelope of the speech/audio frame previous to the foregoing current speech/audio frame and the bandwidth extension envelope of the foregoing current speech/audio frame; or
if the signal class of the foregoing current speech/audio frame is not unvoiced, the signal class of the speech/audio frame next to the foregoing current speech/audio frame is unvoiced, the spectrum tilt factor of the speech/audio frame previous to the foregoing current speech/audio frame is less than or equal to a tenth threshold, modifying the bandwidth extension envelope of the foregoing current speech/audio frame according to a bandwidth extension envelope or the spectrum tilt factor of the speech/audio frame previous to the foregoing current speech/audio frame, to obtain the post-processed bandwidth extension envelope of the foregoing current speech/audio frame.

The tenth threshold may be set to different values according to different application environments or scenarios. For example, the tenth threshold may be set to 0.16, 0.15, 0.165, 0.1, 0.161, or 0.159.

For example, the obtaining the post-processed bandwidth extension envelope of the foregoing current speech/audio frame based on a bandwidth extension envelope of the speech/audio frame previous to the foregoing current speech/audio frame and the bandwidth extension envelope of the foregoing current speech/audio frame may include: specifically obtaining the post-processed bandwidth extension envelope of the foregoing current speech/audio frame based on the bandwidth extension envelope of the speech/audio frame previous to the foregoing current speech/audio frame and the bandwidth extension envelope of the foregoing current speech/audio frame and by using the following formula:

$$GainFrame = fac1 * GainFrame\_old + fac2 * GainFrame\_new,$$

where
*GainFrame* is the post-processed bandwidth extension envelope of the foregoing current speech/audio frame, *GainFrame_old* is the bandwidth extension envelope of the speech/audio frame previous to the foregoing current speech/audio frame, *GainFrame_new* is the bandwidth extension envelope of the foregoing current speech/audio frame, *fac*1 is a weight of the bandwidth extension envelope of the speech/audio frame previous to the foregoing current speech/audio frame, *fac*2 is a weight of the bandwidth extension envelope of the foregoing current speech/audio frame, $fac1 \geq 0$, $fac2 \geq 0$, and *fac1* + *fac2* = 1.

For another example, a modification factor for modifying the bandwidth extension envelope of the foregoing current speech/audio frame is inversely proportional to the spectrum tilt factor of the speech/audio frame previous to the foregoing current speech/audio frame, and is proportional to a ratio of the bandwidth extension envelope of the speech/audio frame previous to the foregoing current speech/audio frame to the bandwidth extension envelope of the foregoing current speech/audio frame.

In other embodiments of the present invention, the speech/audio decoding parameter of the foregoing current speech/audio frame includes a pitch period of the foregoing current speech/audio frame, and the performing post processing on the speech/audio decoding parameter of the foregoing current speech/audio frame according to speech/audio parameters of X speech/audio frames, to obtain a post-processed speech/audio decoding parameter of the foregoing current speech/audio frame may include: performing post processing on the pitch period of the foregoing current speech/audio frame according to the signal classes and/or pitch periods of the X speech/audio frames (for example, post processing such as augmentation or attenuation may be performed on the pitch period of the foregoing current speech/audio frame according to the signal classes and/or the pitch periods of the X speech/audio frames), to obtain a post-processed pitch period of the foregoing current speech/audio frame.

It can be learned from the foregoing description that in some embodiments of the present invention, during transition between an unvoiced speech/audio frame and a non-unvoiced speech/audio frame (for example, when a current speech/audio frame is of an unvoiced signal class and is a redundant decoded frame, and a speech/audio frame previous or next to the current speech/audio frame is of a non unvoiced signal type and is a normal decoded frame, or when a current speech/audio frame is of a non unvoiced signal class and is a normal decoded frame, and a speech/audio frame previous or next to the current speech/audio frame is of an unvoiced signal class and is a redundant decoded frame), post processing is performed on a speech/audio decoding parameter of the current speech/audio frame, which helps avoid a click (click) phenomenon caused during the interframe transition between the unvoiced speech/audio frame and the non-unvoiced speech/audio frame, thereby improving quality of an output speech/audio signal.

In other embodiments of the present invention, during transition between a generic speech/audio frame and a voiced speech/audio frame (when a current speech/audio frame is a generic frame and is a redundant decoded frame, and a speech/audio frame previous or next to the current speech/audio frame is of a voiced signal class and is a normal decoded frame, or when a current speech/audio frame is of a voiced signal class and is a normal decoded frame, and a speech/audio frame previous or next to the current speech/audio frame is of a generic signal class and is a redundant decoded frame), post processing is performed on a speech/audio decoding parameter of the current speech/audio frame, which helps rectify an energy instability phenomenon caused during the transition between a generic frame and a voiced frame, thereby improving quality of an output speech/audio signal.

In still other embodiments of the present invention, when a current speech/audio frame is a redundant decoded frame, a signal class of the current speech/audio frame is not unvoiced, and a signal class of a speech/audio frame next to the current speech/audio frame is unvoiced, a bandwidth extension envelope of the current frame is adjusted, to rectify an energy instability phenomenon in time-domain bandwidth extension, and improve quality of an output speech/audio signal.

To help better understand and implement the foregoing solution in this embodiment of the present invention, some specific application scenarios are used as examples in the following description.

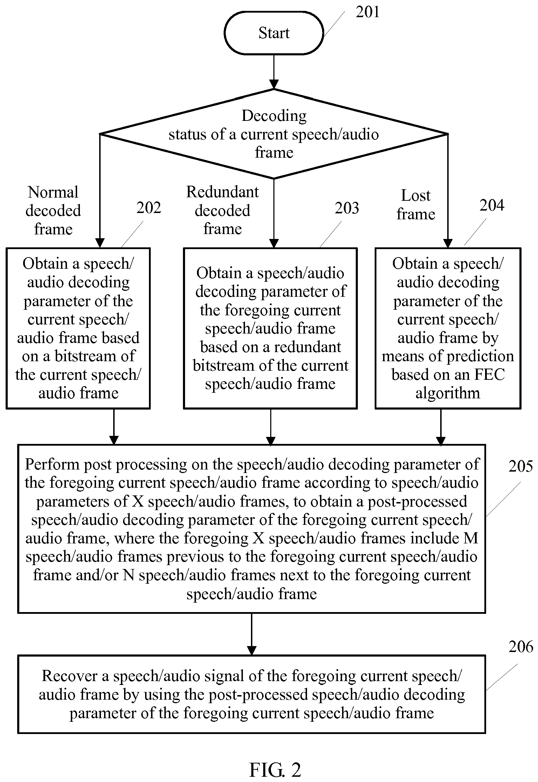

Referring to FIG. 2, FIG. 2 is a schematic flowchart of another speech/audio bitstream decoding method according to another embodiment of the present invention. The another speech/audio bitstream decoding method provided in the another embodiment of the present invention may include the following content:

201. Determine a decoding status of a current speech/audio frame.

Specifically, for example, it may be determined, based on a JBM algorithm or another algorithm, that the current speech/audio frame is a normal decoded frame, a redundant decoded frame, or an FEC recovered frame.

If the current speech/audio frame is a normal decoded frame, and a speech/audio frame previous to the current speech/audio frame is a redundant decoded frame, step 202 is executed.

If the current speech/audio frame is a redundant decoded frame, step 203 is executed.

If the current speech/audio frame is an FEC recovered frame, and a speech/audio frame previous to the foregoing current speech/audio frame is a redundant decoded frame, step 204 is executed.

202. Obtain a speech/audio decoding parameter of the current speech/audio frame based on a bitstream of the current speech/audio frame, and jump to step 205.

203. Obtain a speech/audio decoding parameter of the foregoing current speech/audio frame based on a redundant bitstream of the current speech/audio frame, and jump to step 205.

204. Obtain a speech/audio decoding parameter of the current speech/audio frame by means of prediction based on an FEC algorithm, and jump to step 205.

205. Perform post processing on the speech/audio decoding parameter of the foregoing current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame, and M and N are positive integers.

206. Recover a speech/audio signal of the foregoing current speech/audio frame by using the post-processed speech/audio decoding parameter of the foregoing current speech/audio frame.

Different post processing may be performed on different speech/audio decoding parameters. For example, post processing performed on a spectral pair parameter of the current speech/audio frame may be adaptive weighting performed by using the spectral pair parameter of the current speech/audio frame and a spectral pair parameter of the speech/audio frame previous to the current speech/audio frame, to obtain a post-processed spectral pair parameter of the current speech/audio frame, and post processing performed on an adaptive codebook gain of the current speech/audio frame may be adjustment such as attenuation performed on the adaptive codebook gain.

It may be understood that the details about performing post processing on the speech/audio decoding parameter in this embodiment may refer to related descriptions of the foregoing method embodiments, and details are not described herein.

It can be learned from the foregoing description that in this embodiment, in a scenario in which a current speech/audio frame is a redundant decoded frame or a speech/audio frame previous to the foregoing current speech/audio frame is a redundant decoded frame, after obtaining a speech/audio decoding parameter of the current speech/audio frame, a decoder performs post processing on the speech/audio decoding parameter of the current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame, and recovers a speech/audio signal of the current speech/audio frame by using the post-processed speech/audio decoding parameter of the current speech/audio frame, which ensures stable quality of a decoded signal during transition between a redundant decoded frame and a normal decoded frame or between a redundant decoded frame and an FEC recovered frame, thereby improving quality of an output speech/audio signal.

It can be learned from the foregoing description that in some embodiments of the present invention, during transition between an unvoiced speech/audio frame and a non-unvoiced speech/audio frame (for example, when a current speech/audio frame is of an unvoiced signal class and is a redundant decoded frame, and a speech/audio frame previous or next to the current speech/audio frame is of a non unvoiced signal type and is a normal decoded frame, or when a current speech/audio frame is of a non unvoiced signal class and is a normal decoded frame, and a speech/audio frame previous or next to the current speech/audio frame is of an unvoiced signal class and is a redundant decoded frame), post processing is performed on a speech/audio decoding parameter of the current speech/audio frame, which helps avoid a click (click) phenomenon caused during the interframe transition between the unvoiced speech/audio frame and the non-unvoiced speech/audio frame, thereby improving quality of an output speech/audio signal.

In other embodiments of the present invention, during transition between a generic speech/audio frame and a voiced speech/audio frame (when a current speech/audio frame is a generic frame and is a redundant decoded frame, and a speech/audio frame previous or next to the current speech/audio frame is of a voiced signal class and is a normal decoded frame, or when a current speech/audio frame is of a voiced signal class and is a normal decoded frame, and a speech/audio frame previous or next to the current speech/audio frame is of a generic signal class and is a redundant decoded frame), post processing is performed on a speech/audio decoding parameter of the current speech/audio frame, which helps rectify an energy instability phenomenon caused during the transition between a generic frame and a voiced frame, thereby improving quality of an output speech/audio signal.

In still other embodiments of the present invention, when a current speech/audio frame is a redundant decoded frame, a signal class of the current speech/audio frame is not unvoiced, and a signal class of a speech/audio frame next to the current speech/audio frame is unvoiced, a bandwidth extension envelope of the current frame is adjusted, to rectify an energy instability phenomenon in time-domain bandwidth extension, and improve quality of an output speech/audio signal.

An embodiment of the present invention further provides a related apparatus for implementing the foregoing solution.

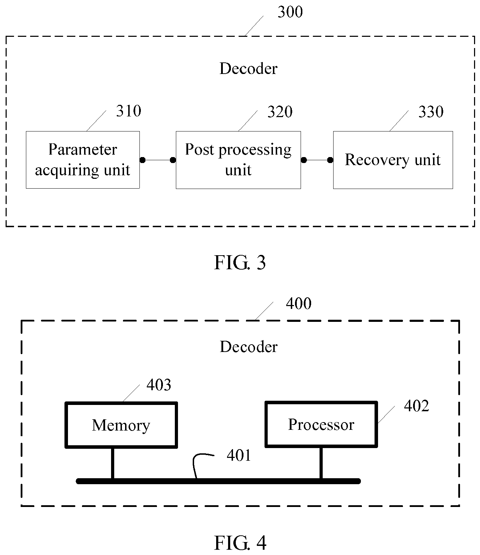

Referring to FIG. 3, an embodiment of the present invention provides a decoder 300 for decoding a speech/audio bitstream, which may include: a parameter acquiring unit 310, a post processing unit 320, and a recovery unit 330.

The parameter acquiring unit 310 is configured to acquire a speech/audio decoding parameter of a current speech/audio frame, where the foregoing current speech/audio frame is a redundant decoded frame or a speech/audio frame previous to the foregoing current speech/audio frame is a redundant decoded frame.

When the speech/audio frame previous to the foregoing current speech/audio frame is a redundant decoded frame, the current speech/audio frame may be a normal decoded frame, a redundant decoded frame, or an FEC recovery frame.

The post processing unit 320 is configured to perform post processing on the speech/audio decoding parameter of the foregoing current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame, and M and N are positive integers.

The recovery unit 330 is configured to recover a speech/audio signal of the foregoing current speech/audio frame by using the post-processed speech/audio decoding parameter of the foregoing current speech/audio frame.

That a speech/audio frame (for example, the current speech/audio frame or the speech/audio frame previous to the current speech/audio frame) is a normal decoded frame means that a speech/audio parameter, and the like of the foregoing speech/audio frame can be directly obtained from a bitstream of the speech/audio frame by means of decoding. That a speech/audio frame (for example, the current speech/audio frame or the speech/audio frame previous to the current speech/audio frame) is a redundant decoded frame means that a speech/audio parameter, and the like of the speech/audio frame cannot be directly obtained from a bitstream of the speech/audio frame by means of decoding, but redundant bitstream information of the speech/audio frame can be obtained from a bitstream of another speech/audio frame.

The M speech/audio frames previous to the current speech/audio frame refer to M speech/audio frames preceding the current speech/audio frame and immediately adjacent to the current speech/audio frame in a time domain.

For example, M may be equal to 1, 2, 3, or another value. When M=1, the M speech/audio frames previous to the current speech/audio frame are the speech/audio frame previous to the current speech/audio frame, and the speech/audio frame previous to the current speech/audio frame and the current speech/audio frame are two immediately adjacent speech/audio frames; when M=2, the M speech/audio frames previous to the current speech/audio frame are the speech/audio frame previous to the current speech/audio frame and a speech/audio frame previous to the speech/audio frame previous to the current speech/audio frame, and the speech/audio frame previous to the current speech/audio frame, the speech/audio frame previous to the speech/audio frame previous to the current speech/audio frame, and the current speech/audio frame are three immediately adjacent speech/audio frames; and so on.

The N speech/audio frames next to the current speech/audio frame refer to N speech/audio frames following the current speech/audio frame and immediately adjacent to the current speech/audio frame in a time domain.

For example, N may be equal to 1, 2, 3, 4, or another value. When N=1, the N speech/audio frames next to the current speech/audio frame are a speech/audio frame next to the current speech/audio frame, and the speech/audio frame next to the current speech/audio frame and the current speech/audio frame are two immediately adjacent speech/audio frames; when N=2, the N speech/audio frames next to the current speech/audio frame are a speech/audio frame next to the current speech/audio frame and a speech/audio frame next to the speech/audio frame next to the current speech/audio frame, and the speech/audio frame next to the current speech/audio frame, the speech/audio frame next to the speech/audio frame next to the current speech/audio frame, and the current speech/audio frame are three immediately adjacent speech/audio frames; and so on.

The speech/audio decoding parameter may include at least one of the following parameters: a bandwidth extension envelope, an adaptive codebook gain (gain_pit), an algebraic codebook, a pitch period, a spectrum tilt factor, a spectral pair parameter, and the like.

The speech/audio parameter may include a speech/audio decoding parameter, a signal class, and the like.

A signal class of a speech/audio frame may be unvoiced, voiced, generic, transient, inactive, or the like.

The spectral pair parameter may be, for example, at least one of a line spectral pair (LSP) parameter or an immittance spectral pair (ISP) parameter.

It may be understood that in this embodiment of the present invention, the post processing unit 320 may perform post processing on at least one speech/audio decoding parameter of a bandwidth extension envelope, an adaptive codebook gain, an algebraic codebook, a pitch period, or a spectral pair parameter of the current speech/audio frame. Specifically, how many parameters are selected and which parameters are selected for post processing may be determined according to an application scenario and an application environment, which is not limited in this embodiment of the present invention.

The post processing unit 320 may perform different post processing on different speech/audio decoding parameters. For example, post processing performed by the post processing unit 320 on the spectral pair parameter of the current speech/audio frame may be adaptive weighting performed by using the spectral pair parameter of the current speech/audio frame and a spectral pair parameter of the speech/audio frame previous to the current speech/audio frame, to obtain a post-processed spectral pair parameter of the current speech/audio frame, and post processing performed by the post processing unit 320 on the adaptive codebook gain of the current speech/audio frame may be adjustment such as attenuation performed on the adaptive codebook gain.

It may be understood that functions of function modules of the decoder 300 in this embodiment may be specifically implemented according to the method in the foregoing method embodiment. For a specific implementation process, refer to related descriptions of the foregoing method embodiment. Details are not described herein. The decoder 300 may be any apparatus that needs to output speeches, for example, a device such as a notebook computer, a tablet computer, or a personal computer, or a mobile phone.

FIG. 4 is a schematic diagram of a decoder 400 according to an embodiment of the present invention. The decoder 400 may include at least one bus 401, at least one processor 402 connected to the bus 401, and at least one memory 403 connected to the bus 401.

By invoking, by using the bus 401, code stored in the memory 403, the processor 402 is configured to perform the steps as described in the previous method embodiments, and the specific implementation process of the processor 402 can refer to related descriptions of the foregoing method embodiments. Details are not described herein.

It may be understood that in this embodiment of the present invention, by invoking the code stored in the memory 403, the processor 402 may be configured to perform post processing on at least one speech/audio decoding parameter of a bandwidth extension envelope, an adaptive codebook gain, an algebraic codebook, a pitch period, or a spectral pair parameter of the current speech/audio frame. Specifically, how many parameters are selected and which parameters are selected for post processing may be determined according to an application scenario and an application environment, which is not limited in this embodiment of the present invention.

Different post processing may be performed on different speech/audio decoding parameters. For example, post processing performed on the spectral pair parameter of the current speech/audio frame may be adaptive weighting performed by using the spectral pair parameter of the current speech/audio frame and a spectral pair parameter of the speech/audio frame previous to the current speech/audio frame, to obtain a post-processed spectral pair parameter of the current speech/audio frame, and post processing performed on the adaptive codebook gain of the current speech/audio frame may be adjustment such as attenuation performed on the adaptive codebook gain.

A specific post processing manner is not limited in this embodiment of the present invention, and specific post processing may be set according to a requirement or according to an application environment and an application scenario.

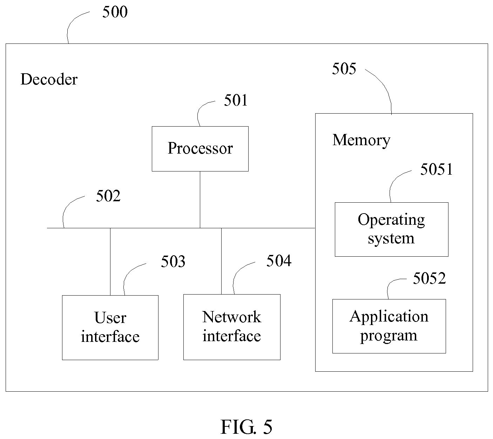

Referring to FIG. 5, FIG. 5 is a structural block diagram of a decoder 500 according to another embodiment of the present invention. The decoder 500 may include at least one processor 501, at least one network interface 504 or user interface 503, a memory 505, and at least one communications bus 502. The communication bus 502 is configured to implement connection and communication between these components. The decoder 500 may optionally include the user interface 503, which includes a display (for example, a touchscreen, an LCD, a CRT, a holographic device, or a projector (Projector)), a click/tap device (for example, a mouse, a trackball (trackball), a touchpad, or a touchscreen), a camera and/or a pickup apparatus, and the like.

The memory 505 may include a read-only memory and a random access memory, and provide an instruction and data for the processor 501. A part of the memory 505 may further include a nonvolatile random access memory (NVRAM).

In some implementation manners, the memory 505 stores the following elements, an executable module or a data structure, or a subset thereof, or an extended set thereof:

an operating system 5051, including various system programs, and used to implement various basic services and process hardware-based tasks; and
an application program module 5052, including various application programs, and configured to implement various application services.

The application program module 5052 includes but is not limited to a parameter acquiring unit 310, a post processing unit 320, a recovery unit 330, and the like.

In this embodiment of the present invention, by invoking a program or an instruction stored in the memory 505, the processor 501 may be configured to perform the steps as described in the previous method embodiments.

It may be understood that in this embodiment, by invoking the program or the instruction stored in the memory 505, the processor 501 may perform post processing on at least one speech/audio decoding parameter of a bandwidth extension envelope, an adaptive codebook gain, an algebraic codebook, a pitch period, or a spectral pair parameter of the current speech/audio frame. Specifically, how many parameters are selected and which parameters are selected for post processing may be determined according to an application scenario and an application environment, which is not limited in this embodiment of the present invention.

Different post processing may be performed on different speech/audio decoding parameters. For example, post processing performed on the spectral pair parameter of the current speech/audio frame may be adaptive weighting performed by using the spectral pair parameter of the current speech/audio frame and a spectral pair parameter of the speech/audio frame previous to the current speech/audio frame, to obtain a post-processed spectral pair parameter of the current speech/audio frame, and post processing performed on the adaptive codebook gain of the current speech/audio frame may be adjustment such as attenuation performed on the adaptive codebook gain. The specific implementation details about the post processing can refer to related descriptions of the foregoing method embodiments

An embodiment of the present invention further provides a computer storage medium, where the computer storage medium may store a program. When being executed, the program includes some or all steps of any speech/audio bitstream decoding method described in the foregoing method embodiments.

It should be noted that, to make the description brief, the foregoing method embodiments are expressed as a series of actions. However, persons skilled in the art should appreciate that the present invention is not limited to the described action sequence, because according to the present invention, some steps may be performed in other sequences or performed simultaneously.

In the foregoing embodiments, the description of each embodiment has respective focuses. For a part that is not described in detail in an embodiment, refer to related descriptions in other embodiments.

In the several embodiments provided in this application, it should be understood that the disclosed apparatus may be implemented in another manner. For example, the described apparatus embodiment is merely exemplary. For example, the unit division is merely logical function division and may be other division in actual implementation. For example, multiple units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic or other forms.

The units described as separate parts may or may not be physically separate, and parts displayed as units may or may not be physical units, may be located in one position, or may be distributed on multiple network units. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a computer-readable storage medium. Based on such an understanding, the technical solutions of the present invention essentially, or the part contributing to the prior art, or all or a part of the technical solutions may be implemented in the form of a software product. The software product is stored in a storage medium and includes several instructions for instructing a computer device (which may be a personal computer, a server, or a network device, and may specifically be a processor in a computer device) to perform all or a part of the steps of the foregoing methods described in the embodiments of the present invention. The foregoing storage medium may include: any medium that can store program code, such as a USB flash drive, a magnetic disk, a random access memory (RAM, random access memory), a read-only memory (ROM, read-only memory), a removable hard disk, or an optical disc.

The foregoing embodiments are merely intended for describing the technical solutions of the present invention, but not for limiting the present invention.

**Claims**

1. A speech/audio bitstream decoding method, comprising:

   acquiring (101) a speech/audio decoding parameter of a current speech/audio frame, wherein the current speech/audio frame is a redundant decoded frame or a speech/audio frame previous to the current speech/audio frame is a redundant decoded frame; wherein the speech/audio decoding parameter comprises at least one of the following parameters: a bandwidth extension envelope, an adaptive codebook gain, an algebraic codebook, a pitch period and a spectral pair parameter;
   performing (102) post processing on the speech/audio decoding parameter of the current speech/audio frame according to speech/audio parameters of X speech/audio frames, to obtain a post-processed speech/audio decoding parameter of the current speech/audio frame, wherein the X speech/audio frames comprise M speech/audio frames previous to the current speech/audio frame and/or N speech/audio frames next to the current speech/audio frame, and M and N are positive integers;
   wherein the speech/audio parameter of the current speech/audio frame comprises a speech/audio decoding parameter and a signal class of the speech/audio frame; and
   recovering (103) a speech/audio signal of the current speech/audio frame by using the post-processed speech/audio decoding parameter of the current speech/audio frame;
   wherein the speech/audio decoding parameter of the current speech/audio frame comprises an adaptive codebook gain of the current speech/audio frame, and performing post processing on the speech/audio decoding parameter of the current speech/audio frame comprises:

      performing post processing on the adaptive codebook gain of the current speech/audio frame according to a signal class and an algebraic codebook gain of the X speech/audio frames, to obtain a post-processed adaptive codebook gain of the current speech/audio frame;
      wherein the performing post processing on the adaptive codebook gain of the current speech/audio frame according to the signal class and the algebraic codebook gain of the X speech/audio frames comprises:

         if the current speech/audio frame is a redundant decoded frame, the signal class of the current speech/audio frame is not unvoiced, a signal class of at least one of two speech/audio frames next to the current speech/audio frame is unvoiced, and an algebraic codebook gain of a current subframe of the current speech/audio frame is greater than or equal to an algebraic codebook gain of the speech/audio frame previous to the current speech/audio frame, attenuating an adaptive codebook gain of the current subframe; or
         if the current speech/audio frame is a redundant decoded frame, the signal class of the current speech/audio frame is not unvoiced, a signal class of at least one of two speech/audio frames next to the current speech/audio frame is unvoiced, and an algebraic codebook gain of a current subframe of the current speech/audio frame is greater than or equal to an algebraic codebook gain of a subframe previous to the current subframe, attenuating an adaptive codebook gain of the current subframe.

**2.** The method according to claim 1, wherein the speech/audio decoding parameter of the current speech/audio frame further comprises a bandwidth extension envelope of the current speech/audio frame, and performing post processing on the speech/audio decoding parameter of the current speech/audio frame according to speech/audio parameters of X speech/audio frames, to obtain a post-processed speech/audio decoding parameter of the current speech/audio frame comprises: performing post processing on the bandwidth extension envelope of the current speech/audio frame according to at least one of the signal class, a bandwidth extension envelope, or the spectrum tilt factor of the X speech/audio frames, to obtain a post-processed bandwidth extension envelope of the current speech/audio frame.

**3.** The method according to claim 2, wherein performing post processing on the bandwidth extension envelope of the current speech/audio frame according to at least one of the signal class, a bandwidth extension envelope, or the spectrum tilt factor of the X speech/audio frames comprises:

when the speech/audio frame previous to the current speech/audio frame is a normal decoded frame, and the signal class of the speech/audio frame previous to the current speech/audio frame is the same as that of the speech/audio frame next to the current speech/audio frame, obtaining the post-processed bandwidth extension envelope of the current speech/audio frame based on a bandwidth extension envelope of the speech/audio frame previous to the current speech/audio frame and the bandwidth extension envelope of the current speech/audio frame; or

when the signal class of the current speech/audio frame is not unvoiced, the signal class of the speech/audio frame next to the current speech/audio frame is unvoiced, and the spectrum tilt factor of the speech/audio frame previous to the current speech/audio frame is less than or equal to a tenth threshold, modifying the bandwidth extension envelope of the current speech/audio frame according to a bandwidth extension envelope or the spectrum tilt factor of the speech/audio frame previous to the current speech/audio frame, to obtain the post-processed bandwidth extension envelope of the current speech/audio frame.

**4.** The method according to claim 3, wherein obtaining the post-processed bandwidth extension envelope of the current speech/audio frame based on a bandwidth extension envelope of the speech/audio frame previous to the current speech/audio frame and the bandwidth extension envelope of the current speech/audio frame comprises: obtaining the post-processed bandwidth extension envelope of the current speech/audio frame by using the following formula:

$$GainFrame = fac1 * GainFrame\_old + fac2 * GainFrame\_new,$$

Wherein *GainFrame* is the post-processed bandwidth extension envelope of the current speech/audio frame, *GainFrame_old* is the bandwidth extension envelope of the speech/audio frame previous to the current speech/audio frame, *GainFrame_new* is the bandwidth extension envelope of the current speech/audio frame, *fac*1 is a weight of the bandwidth extension envelope of the speech/audio frame previous to the current speech/audio frame, *fac*2 is a weight of the bandwidth extension envelope of the current speech/audio frame, $fac1 \geq 0$, $fac2 \geq 0$, and $fac1 + fac2 = 1$.

**5.** A decoder for decoding a speech/audio bitstream, comprising:

a parameter acquiring unit (310), configured to acquire a speech/audio decoding parameter of a current speech/audio frame, wherein the current speech/audio frame is a redundant decoded frame or a speech/audio frame previous to the current speech/audio frame is a redundant decoded frame; wherein the speech/audio decoding parameter comprises at least one of the following parameters: a bandwidth extension envelope, an adaptive codebook gain, an algebraic codebook, a pitch period and a spectral pair parameter;
a post processing unit (320), configured to perform post processing on the speech/audio decoding parameter of the current speech/audio frame according to speech/audio parameters of X speech/audio frames, to obtain a post-processed speech/audio decoding parameter of the current speech/audio frame, wherein the X speech/audio frames comprise M speech/audio frames previous to the current speech/audio frame and/or N speech/audio frames next to the current speech/audio frame, and M and N are positive integers;
wherein the speech/audio parameter of the current speech/audio frame comprises a speech/audio decoding parameter and a signal class of the speech/audio frame; and
a recovery unit (330), configured to recover a speech/audio signal of the current speech/audio frame by using the post-processed speech/audio decoding parameter of the current speech/audio frame;

wherein the post processing unit (320) is configured to: perform post processing on the adaptive codebook gain of the current speech/audio frame according to a signal class and an algebraic codebook gain the X speech/audio frames, to obtain a post-processed adaptive codebook gain of the current speech/audio frame;
wherein the post processing unit is specifically configured to:

if the current speech/audio frame is a redundant decoded frame, the signal class of the current speech/audio frame is not unvoiced, a signal class of at least one of two speech/audio frames next to the current speech/audio frame is unvoiced, and an algebraic codebook gain of a current subframe of the current speech/audio frame is greater than or equal to an algebraic codebook gain of the speech/audio frame previous to the current speech/audio frame, attenuate an adaptive codebook gain of the current subframe; or
if the current speech/audio frame is a redundant decoded frame, the signal class of the current speech/audio frame is not unvoiced, a signal class of at least one of two speech/audio frames next to the current speech/audio frame is unvoiced, and an algebraic codebook gain of a current subframe of the current speech/audio frame is greater than or equal to an algebraic codebook gain of a subframe previous to the current subframe, attenuate an adaptive codebook gain of the current subframe.

6. The decoder according to claim 5, wherein the speech/audio decoding parameter of the current speech/audio frame further comprises a bandwidth extension envelope of the current speech/audio frame, and the post processing unit (320) is configured to: perform post processing on the bandwidth extension envelope of the current speech/audio frame according to at least one of the signal class, a bandwidth extension envelope, or the spectrum tilt factor of the X speech/audio frames, to obtain a post-processed bandwidth extension envelope of the current speech/audio frame.

7. The decoder according to claim 6, wherein in the aspect of performing post processing on the bandwidth extension envelope of the current speech/audio frame, the post processing unit (320) is specifically configured to:

when the speech/audio frame previous to the current speech/audio frame is a normal decoded frame, and the signal class of the speech/audio frame previous to the current speech/audio frame is the same as that of the speech/audio frame next to the current speech/audio frame, obtain the post-processed bandwidth extension envelope of the current speech/audio frame based on a bandwidth extension envelope of the speech/audio frame previous to the current speech/audio frame and the bandwidth extension envelope of the current speech/audio frame; or
when the signal class of the current speech/audio frame is not unvoiced, the signal class of the speech/audio frame next to the current speech/audio frame is unvoiced, and the spectrum tilt factor of the speech/audio frame previous to the current speech/audio frame is less than or equal to a tenth threshold, modify the bandwidth extension envelope of the current speech/audio frame according to a bandwidth extension envelope or the spectrum tilt factor of the speech/audio frame previous to the current speech/audio frame, to obtain the post-processed bandwidth extension envelope of the current speech/audio frame.

8. A computer program product comprising a program with instructions which, when executed by a processor, cause the processor to perform the steps of any one of claims 1 to 4.

**Patentansprüche**

1. Decodierverfahren für einen Sprach-/Audio-Bitstrom, umfassend:

Erfassen (101) eines Sprach-/Audio-Decodierparameters eines aktuellen Sprach-/Audio-Frames, wobei der aktuelle Sprach-/Audio-Frame ein redundanter decodierter Frame ist, oder ein Sprach-/Audio-Frame vor dem aktuellen Sprach-/Audio-Frame ein redundanter decodierter Frame ist; wobei der Sprach-/Audio-Decodierparameter mindestens einen der folgenden Parameter umfasst: eine Bandbreitenerweiterungshüllkurve, eine adaptive Codebuchverstärkung, ein algebraisches Codebuch, eine Tonhöhenperiode und einen Spektralpaarparameter;
Durchführen (102) von Nachverarbeitung mit dem Sprach-/Audio-Parameter des aktuellen Sprach-/Audio-Frames gemäß den Sprach-/Audio-Parametem von X Sprach-/Audio-Frames, um einen nachverarbeiteten Sprach-/Audio-Decodierparameter des aktuellen Sprach-/Audio-Frames zu erhalten, wobei die X Sprach-/Audio-Frames M Sprach-/Audio-Frames vor dem aktuellen Sprach-/Audio-Frame und/oder N Sprach-/Audio-Frames nach dem aktuellen Sprach-/Audio-Frame umfassen, und M und N positive ganze Zahlen sind;

wobei die Sprach-/Audio-Parameter des aktuellen Sprach-/Audio-Frames einen Sprach-/Audio-Decodierparameter und eine Signalklasse des Sprach-/Audio-Frames umfassen; und

Wiederherstellen (103) eines Sprach-/Audio-Signals des aktuellen Sprach/Audio-Frames durch Verwendung des nachverarbeiteten Sprach-/Audio-Decodierparameters des aktuellen Sprach-/Audio-Frames;

wobei der Sprach-/Audio-Decodierparameter des aktuellen Sprach-/Audio-Frames eine adaptive Codebuchverstärkung des aktuellen Sprach-/Audio-Frames umfasst, und Durchführen von Nachverarbeitung mit den Sprach-/Audio-Decodierparametern des aktuellen Sprach-/Audio-Frames umfasst:

Durchführen von Nachverarbeitung mit der adaptiven Codebuchverstärkung des aktuellen Sprach-/Audio-Frames gemäß einer Signalklasse und einer algebraischen Codebuchverstärkung der X Sprach-/Audio-Frames, um eine nachverarbeitete adaptive Codebuchverstärkung des aktuellen Sprach-/Audio-Frames zu erhalten;

wobei das Durchführen von Nachverarbeitung mit der adaptiven Codebuchverstärkung des aktuellen Sprach-/Audio-Frames gemäß der Signalklasse und der algebraischen Codebuchverstärkung der X Sprach-/Audio-Frames umfasst:

falls der aktuelle Sprach-/Audio-Frame ein redundanter decodierter Frame ist, die Signalklasse des aktuellen Sprach-Audio-Frames nicht stimmlos ist, eine Signalklasse von mindestens einem der beiden Sprach-/Audio-Frames nach dem aktuellen Sprach-/Audio-Frame stimmlos ist, und eine algebraische Codebuchverstärkung eines aktuellen Teilframes des aktuellen Sprach-/Audio-Frames größer als oder gleich einer algebraischen Codebuchverstärkung des Sprach-/Audio-Frames vor dem aktuellen Sprach-/Audio-Frame ist, Abschwächen einer adaptiven Codebuchverstärkung des aktuellen Teilframes; oder

falls der aktuelle Sprach-/Audio-Frame ein redundanter decodierter Frame ist, die Signalklasse des aktuellen Sprach-Audio-Frames nicht stimmlos ist, eine Signalklasse von mindestens einem der beiden Sprach-/Audio-Frames nach dem aktuellen Sprach-/Audio-Frame stimmlos ist, und eine algebraische Codebuchverstärkung eines aktuellen Teilframes des aktuellen Sprach-/Audio-Frames größer als oder gleich einer algebraischen Codebuchverstärkung eines Teilframes vor dem aktuellen Teilframe ist, Abschwächen einer adaptiven Codebuchverstärkung des aktuellen Teilframes.

2. Verfahren nach Anspruch 1, wobei der Sprach-/Audio-Decodierparameter des aktuellen Sprach-/Audio-Frames des Weiteren eine Bandbreitenerweiterungshüllkurve des aktuellen Sprach-/Audio-Frames umfasst, und Durchführen von Nachverarbeitung mit dem Sprach-/Audio-Decodierparameter des aktuellen Sprach-/Audio-Frames gemäß Sprach-/Audio-Decodierparametern von X Sprach-/Audio-Frames, um einen nachverarbeiteten Sprach-/Audio-Decodierparameter des aktuellen Sprach-/Audio-Frames zu erhalten, umfasst: Durchführen von Nachverarbeitung mit der Bandbreitenerweiterungshüllkurve des aktuellen Sprach-/Audio-Frames gemäß mindestens einem von der Signalklasse, einer Bandbreitenerweiterungshüllkurve oder dem Spektrum-Tilt-Faktor der X Sprach-/Audio-Frames, um eine nachverarbeitete Bandbreitenerweiterungshüllkurve des aktuellen Sprach-/Audio-Frames zu erhalten.

3. Verfahren nach Anspruch 2, wobei Durchführen von Nachverarbeitung mit der Bandbreitenerweiterungshüllkurve des aktuellen Sprach-/Audio-Frames gemäß mindestens einem von der Signalklasse, einer Bandbreitenerweiterungshüllkurve oder dem Spektrum-Tilt-Faktor der X Sprach-/Audio-Frames umfasst:

wenn der Sprach-/Audio-Frame vor dem aktuellen Sprach-/Audio-Frame ein normaler decodierter Frame ist, und die Signalklasse des Sprach-/Audio-Frames vor dem aktuellen Sprach-/Audio-Frame dieselbe wie diejenige des Sprach-/Audio-Frames nach dem aktuellen Sprach-/Audio-Frame ist, Erhalten der nachverarbeiteten Bandbreitenerweiterungshüllkurve des aktuellen Sprach-/Audio-Frames basierend auf einer Bandbreitenerweiterungshüllkurve des Sprach-/Audio-Frames vor dem aktuellen Sprach-/Audio-Frame und der Bandbreitenerweiterungshüllkurve des aktuellen Sprach-/Audio-Frames; oder

wenn die Signalklasse des aktuellen Sprach-/Audio-Frames nicht stimmlos ist, die Signalklasse des Sprach-/Audio-Frames nach dem aktuellen Sprach-/Audio-Frame stimmlos ist, und der Spektrum-Tilt-Faktor des Sprach-/Audio-Frames vor dem aktuellen Sprach-/Audio-Frame kleiner als oder gleich einem zehnten Schwellenwert ist, Modifizieren der Bandbreitenerweiterungshüllkurve des aktuellen Sprach-/Audio-Frames gemäß einer Bandbreitenerweiterungshüllkurve oder dem Spektrum-Tilt-Faktor des Sprach-/Audio-Frames vor dem aktuellen Sprach-/Audio-Frame, um die nachverarbeitete Bandbreitenerweiterungshüllkurve des aktuellen Sprach-/Audio-Frames zu erhalten.

4. Verfahren nach Anspruch 3, wobei Erhalten der nachverarbeiteten Bandbreitenerweiterungshüllkurve des aktuellen Sprach-/Audio-Frames basierend auf einer Bandbreitenerweiterungshüllkurve des Sprach-/Audio-Frames vor dem aktuellen Sprach-/Audio-Frame und der Bandbreitenerweiterungshüllkurve des aktuellen Sprach-/Audio-Frames umfasst:

Erhalten der nachverarbeiteten Bandbreitenerweiterungshüllkurve des aktuellen Sprach-/Audio-Frames unter Verwendung der folgenden Formel:

$$VerstärkungFrame = fac1 * VerstärkungFrame\_alt + fac2 * VerstärkungFrame\_neu$$

wobei *VerstärkungFrame* die nachverarbeitete Bandbreitenhüllkurve des aktuellen Sprach-/Audio-Frames ist, *VerstärkungFrame_alt* die Bandbreitenerweiterungshüllkurve des Sprach-/Audio-Frames vor dem aktuellen Sprach-/Audio-Frame ist, *VerstärkungFrame_neu* die Bandbreitenerweiterungshüllkurve des aktuellen Sprach-/Audio-Frames ist, *fac*1 eine Gewichtung der Bandbreitenerweiterungshüllkurve des Sprach-/Audio-Frames vor dem aktuellen Sprach-/Audio-Frame ist, *fac2* eine Gewichtung der Bandbreitenerweiterungshüllkurve des aktuellen Sprach-/Audio-Frames ist, *fac*1 $\geq$ 0, *fac2* $\geq$ 0 und *fac*1 + *fac2* = 1.

5. Decoder zum Decodieren eines Sprach-/Audio-Bitstroms, umfassend:

eine Parametererfassungseinheit (310), die zum Erfassen eines Sprach-/Audio-Decodierparameters eines aktuellen Sprach-/Audio-Frames konfiguriert ist, wobei der aktuelle Sprach-/Audio-Frame ein redundanter decodierter Frame ist, oder ein Sprach-/Audio-Frame vor dem aktuellen Sprach-/Audio-Frame ein redundanter decodierter Frame ist; wobei der Sprach-/Audio-Decodierparameter mindestens einen der folgenden Parameter umfasst: eine Bandbreitenerweiterungshüllkurve, eine adaptive Codebuchverstärkung, ein algebraisches Codebuch, eine Tonhöhenperiode und einen Spektralpaarparameter;

eine Nachverarbeitungseinheit (320), die zum Durchführen von Nachverarbeitung mit dem Sprach-/Audio-Parameter des aktuellen Sprach-/Audio-Frames gemäß den Sprach-/Audio-Parametern von X Sprach-/Audio-Frames konfiguriert ist, um einen nachverarbeiteten Sprach-/Audio-Decodierparameter des aktuellen Sprach-/Audio-Frames zu erhalten, wobei die X Sprach-/Audio-Frames M Sprach-/Audio-Frames vor dem aktuellen Sprach-/Audio-Frame und/oder N Sprach-/Audio-Frames nach dem aktuellen Sprach-/Audio-Frame umfassen, und M und N positive ganze Zahlen sind;

wobei die Sprach-/Audio-Parameter des aktuellen Sprach-/Audio-Frames einen Sprach-/Audio-Decodierparameter und eine Signalklasse des Sprach-/Audio-Frames umfassen; und

eine Wiederherstellungseinheit (330), die zum Wiederherstellen eines Sprach-/Audio-Signals des aktuellen Sprach/Audio-Frames durch Verwenden des nachverarbeiteten Sprach-/Audio-Decodierparameters des aktuellen Sprach-/Audio-Frames konfiguriert ist;

wobei die Nachverarbeitungseinheit (320) zum Durchführen von Nachverarbeitung mit der adaptiven Codebuchverstärkung des aktuellen Sprach-/Audio-Frames gemäß einer Signalklasse und einer algebraischen Codebuchverstärkung der X Sprach-/Audio-Frames konfiguriert ist, um eine nachverarbeitete adaptive Codebuchverstärkung des aktuellen Sprach-/Audio-Frames zu erhalten;

wobei die Nachverarbeitungseinheit speziell für Folgendes konfiguriert ist:

falls der aktuelle Sprach-/Audio-Frame ein redundanter decodierter Frame ist, die Signalklasse des aktuellen Sprach-Audio-Frames nicht stimmlos ist, eine Signalklasse von mindestens einem der beiden Sprach-/Audio-Frames nach dem aktuellen Sprach-/Audio-Frame stimmlos ist, und eine algebraische Codebuchverstärkung eines aktuellen Teilframes des aktuellen Sprach-/Audio-Frames größer als oder gleich einer algebraischen Codebuchverstärkung des Sprach-/Audio-Frames vor dem aktuellen Sprach-/Audio-Frame ist, Abschwächen einer adaptiven Codebuchverstärkung des aktuellen Teilframes; oder

falls der aktuelle Sprach-/Audio-Frame ein redundanter decodierter Frame ist, die Signalklasse des aktuellen Sprach-Audio-Frames nicht stimmlos ist, eine Signalklasse von mindestens einem der beiden Sprach-/Audio-Frames nach dem aktuellen Sprach-/Audio-Frame stimmlos ist, und eine algebraische Codebuchverstärkung eines aktuellen Teilframes des aktuellen Sprach-/Audio-Frames größer als oder gleich einer algebraischen Codebuchverstärkung eines Teilframes vor dem aktuellen Teilframe ist, Abschwächen einer adaptiven Codebuchverstärkung des aktuellen Teilframes.

6. Decoder nach Anspruch 5, wobei der Sprach-/Audio-Decodierparameter des aktuellen Sprach-/Audio-Frames des Weiteren eine Bandbreitenerweiterungshüllkurve des aktuellen Sprach-/Audio-Frames umfasst, und die Nachverarbeitungseinheit (320) zum Durchführen von Nachverarbeitung mit der Bandbreitenerweiterungshüllkurve des aktuellen Sprach-/Audio-Frames gemäß mindestens einem von der Signalklasse, einer Bandbreitenerweiterungshüllkurve oder dem Spektrum-Tilt-Faktor der X Sprach-/Audio-Frames konfiguriert ist, um eine nachverarbeitete Bandbreitenerweiterungshüllkurve des aktuellen Sprach-/Audio-Frames zu erhalten.

**7.** Decoder nach Anspruch 6, wobei in dem Aspekt des Durchführens von Nachverarbeitung mit der Bandbreitenerweiterungshüllkurve des aktuellen Sprach-/Audio-Frames die Nachverarbeitungseinheit (320) speziell konfiguriert ist zum:

Erhalten der nachverarbeiteten Bandbreitenerweiterungshüllkurve des aktuellen Sprach-/Audio-Frames basierend auf einer Bandbreitenerweiterungshüllkurve des Sprach-/Audio-Frames vor dem aktuellen Sprach-/Audio-Frame und der Bandbreitenerweiterungshüllkurve des aktuellen Sprach-/Audio-Frames, wenn der Sprach-/Audio-Frame vor dem aktuellen Sprach-/Audio-Frame ein normaler decodierter Frame ist, und die Signalklasse des Sprach-/Audio-Frames vor dem aktuellen Sprach-/Audio-Frame dieselbe wie diejenige des Sprach-/Audio-Frames nach dem aktuellen Sprach-/Audio-Frame ist; oder

Modifizieren der Bandbreitenerweiterungshüllkurve des aktuellen Sprach-/Audio-Frames gemäß einer Bandbreitenerweiterungshüllkurve oder dem Spektrum-Tilt-Faktor des Sprach-/Audio-Frames vor dem aktuellen Sprach-/Audio-Frame, um die nachverarbeitete Bandbreitenerweiterungshüllkurve des aktuellen Sprach-/Audio-Frames zu erhalten, wenn die Signalklasse des aktuellen Sprach-/Audio-Frames nicht stimmlos ist, die Signalklasse des Sprach-/Audio-Frames nach dem aktuellen Sprach-/Audio-Frame stimmlos ist, und der Spektrum-Tilt-Faktor des Sprach-/Audio-Frames vor dem aktuellen Sprach-/Audio-Frame kleiner als oder gleich einem zehnten Schwellenwert ist.

**8.** Computerprogrammprodukt, umfassend ein Programm mit Anweisungen, die bei Ausführung mittels eines Prozessors bewirken, dass der Prozessor die Schritte gemäß einem der Ansprüche 1 bis 4 durchführt.

**Revendications**

**1.** Procédé de décodage d'un flux binaire vocal/audio, consistant à :

acquérir (101) un paramètre de décodage vocal/audio d'une trame vocale/audio courante, la trame vocale/audio courante étant une trame décodée redondante ou une trame vocale/audio antérieure à la trame vocale/audio courante étant une trame décodée redondante ; le paramètre de décodage vocal/audio comprenant au moins un des paramètres suivants : une enveloppe d'extension de bande passante, un gain de livre de codes adaptatif, un livre de codes algébrique, une période de hauteur et un paramètre de paire spectrale ;
réaliser (102) un post-traitement sur le paramètre de décodage vocal/audio de la trame vocale/audio courante selon des paramètres vocaux/audio de X trames vocales/audio, afin d'obtenir un paramètre de décodage vocal/audio post-traité de la trame vocale/audio courante, les X trames vocales/audio comprenant M trames vocales/audio antérieures à la trame vocale/audio courante et/ou N trames vocales/audio postérieures à la trame vocale/audio courante, et M et N étant des entiers positifs ;
le paramètre vocal/audio de la trame vocale/audio courante comprenant un paramètre de décodage vocal/audio et une classe de signal de la trame vocale/audio ; et
récupérer (103) un signal vocal/audio de la trame vocale/audio courante au moyen du paramètre de décodage vocal/audio post-traité de la trame vocale/audio courante ;
le paramètre de décodage vocal/audio de la trame vocale/audio courante comprenant un gain de livre de codes adaptatif de la trame vocale/audio courante, et la réalisation d'un post-traitement sur le paramètre de décodage vocal/audio de la trame vocale/audio courante consistant à :

réaliser un post-traitement sur le gain de livre de codes adaptatif de la trame vocale/audio courante selon une classe de signal et un gain de livre de codes algébrique des X trames vocales/audio, afin d'obtenir un gain de livre de codes adaptatif post-traité de la trame vocale/audio courante ;
la réalisation d'un post-traitement sur le gain de livre de codes adaptatif de la trame vocale/audio courante selon la classe de signal et le gain de livre de codes algébrique des X trames vocales/audio consistant à :

si la trame vocale/audio courante est une trame décodée redondante, la classe de signal de la trame vocale/audio courante n'est pas muette, une classe de signal d'au moins une de deux trames vocales/audio postérieures à la trame vocale/audio courante est muette et un gain de livre de codes algébrique d'une sous-trame courante de la trame vocale/audio courante est supérieur ou égal à un gain

**20**

de livre de codes algébrique de la trame vocale/audio antérieure à la trame vocale/audio courante, atténuer un gain de livre de codes adaptatif de la sous-trame courante ; ou

si la trame vocale/audio courante est une trame décodée redondante, la classe de signal de la trame vocale/audio courante n'est pas muette, une classe de signal d'au moins une de deux trames vocales/audio postérieures à la trame vocale/audio courante est muette et un gain de livre de codes algébrique d'une sous-trame courante de la trame vocale/audio courante est supérieur ou égal à un gain de livre de codes algébrique d'une sous-trame antérieure à la sous-trame courante, atténuer un gain de livre de codes adaptatif de la sous-trame courante.

2.  Procédé selon la revendication 1, dans lequel le paramètre de décodage vocal/audio de la trame vocale/audio courante comprend en outre une enveloppe d'extension de bande passante de la trame vocale/audio courante, et dans lequel la réalisation d'un post-traitement sur le paramètre de décodage vocal/audio de la trame vocale/audio courante selon des paramètres vocaux/audio de X trames vocales/audio, afin d'obtenir un paramètre de décodage vocal/audio post-traité de la trame vocale/audio courante consiste à : réaliser un post-traitement sur l'enveloppe d'extension de bande passante de la trame vocale/audio courante selon au moins un paramètre parmi la classe de signal, une enveloppe d'extension de bande passante et le facteur d'inclinaison de spectre des X trames vocales/audio, afin d'obtenir une enveloppe d'extension de bande passante post-traitée de la trame vocale/audio courante.

3.  Procédé selon la revendication 2, dans lequel la réalisation d'un post-traitement sur l'enveloppe d'extension de bande passante de la trame vocale/audio courante selon au moins un paramètre parmi la classe de signal, une enveloppe d'extension de bande passante et le facteur d'inclinaison de spectre des X trames vocales/audio consiste à : quand la trame vocale/audio antérieure à la trame vocale/audio courante est une trame décodée normale, et la classe de signal de la trame vocale/audio antérieure à la trame vocale/audio courante est la même que celle de la trame vocale/audio postérieure à la trame vocale/audio courante, obtenir l'enveloppe d'extension de bande passante post-traitée de la trame vocale/audio courante sur la base d'une enveloppe d'extension de bande passante de la trame vocale/audio antérieure à la trame vocale/audio courante et de l'enveloppe d'extension de bande passante de la trame vocale/audio courante ; ou quand la classe de signal de la trame vocale/audio courante n'est pas muette, la classe de signal de la trame vocale/audio postérieure à la trame vocale/audio courante est muette et le facteur d'inclinaison de spectre de la trame vocale/audio antérieure à la trame vocale/audio courante est inférieur ou égal à un dixième seuil, modifier l'enveloppe d'extension de bande passante de la trame vocale/audio courante selon une enveloppe d'extension de bande passante ou le facteur d'inclinaison de spectre de la trame vocale/audio antérieure à la trame vocale/audio courante, afin d'obtenir l'enveloppe d'extension de bande passante post-traitée de la trame vocale/audio courante.

4.  Procédé selon la revendication 3, dans lequel l'obtention de l'enveloppe d'extension de bande passante post-traitée de la trame vocale/audio courante sur la base d'une enveloppe d'extension de bande passante de la trame vocale/audio antérieure à la trame vocale/audio courante et de l'enveloppe d'extension de bande passante de la trame vocale/audio courante consiste à : obtenir l'enveloppe d'extension de bande passante post-traitée de la trame vocale/audio courante au moyen de la formule suivante :

$$GainTrame = fac1 * GainTrame\_ancienne + fac2 * GainTrame\_nouvelle,$$

où *GainTrame* est l'enveloppe d'extension de bande passante post-traitée de la trame vocale/audio courante, *GainTrame_ancienne* est l'enveloppe d'extension de bande passante de la trame audio/vocale antérieure à la trame vocale/audio courante, *GainTrame_nouvelle* est l'enveloppe d'extension de bande passante de la trame vocale/audio courante, *fac1* est une pondération de l'enveloppe d'extension de bande passante de la trame vocale/audio antérieure à la trame vocale/audio courante, *fac2* est une pondération de l'enveloppe d'extension de bande passante de la trame vocale/audio courante, $fac1 \geq 0, fac2 \geq 0$ et *fac1* +*fac2* = 1.

5.  Décodeur de décodage d'un flux binaire vocal/audio, comprenant :

une unité d'acquisition de paramètre (310), configurée pour acquérir un paramètre de décodage vocal/audio d'une trame vocale/audio courante, la trame vocale/audio courante étant une trame décodée redondante ou une trame vocale/audio antérieure à la trame vocale/audio courante étant une trame décodée redondante ; le paramètre de décodage vocal/audio comprenant au moins un des paramètres suivants : une enveloppe d'extension de bande passante, un gain de livre de codes adaptatif, un livre de codes algébrique, une période de hauteur et un paramètre de paire spectrale ;

une unité de post-traitement (320), configurée pour réaliser un post-traitement sur le paramètre de décodage vocal/audio de la trame vocale/audio courante selon des paramètres vocaux/audio de X trames vocales/audio, afin d'obtenir un paramètre de décodage vocal/audio post-traité de la trame vocale/audio courante, les X trames vocales/audio comprenant M trames vocales/audio antérieures à la trame vocale/audio courante et/ou N trames vocales/audio postérieures à la trame vocale/audio courante, et M et N étant des entiers positifs ;

le paramètre vocal/audio de la trame vocale/audio courante comprenant un paramètre de décodage vocal/audio et une classe de signal de la trame vocale/audio ; et

une unité de récupération (330), configurée pour récupérer un signal vocal/audio de la trame vocale/audio courante au moyen du paramètre de décodage vocal/audio post-traité de la trame vocale/audio courante ;

l'unité de post-traitement (320) étant configurée pour : réaliser un post-traitement sur le gain de livre de codes adaptatif de la trame vocale/audio courante selon une classe de signal et un gain de livre de codes algébrique des X trames vocales/audio, afin d'obtenir un gain de livre de codes adaptatif post-traité de la trame vocale/audio courante ;

l'unité de post-traitement étant spécifiquement configurée pour :

si la trame vocale/audio courante est une trame décodée redondante, la classe de signal de la trame vocale/audio courante n'est pas muette, une classe de signal d'au moins une de deux trames vocales/audio postérieures à la trame vocale/audio courante est muette et un gain de livre de codes algébrique d'une sous-trame courante de la trame vocale/audio courante est supérieur ou égal à un gain de livre de codes algébrique de la trame vocale/audio antérieure à la trame vocale/audio courante, atténuer un gain de livre de codes adaptatif de la sous-trame courante ; ou

si la trame vocale/audio courante est une trame décodée redondante, la classe de signal de la trame vocale/audio courante n'est pas muette, une classe de signal d'au moins une de deux trames vocales/audio postérieures à la trame vocale/audio courante est muette et un gain de livre de codes algébrique d'une sous-trame courante de la trame vocale/audio courante est supérieur ou égal à un gain de livre de codes algébrique d'une sous-trame antérieure à la sous-trame courante, atténuer un gain de livre de codes adaptatif de la sous-trame courante.

6. Décodeur selon la revendication 5, dans lequel le paramètre de décodage vocal/audio de la trame vocale/audio courante comprend en outre une enveloppe d'extension de bande passante de la trame vocale/audio courante, et dans lequel l'unité de post-traitement (320) est configurée pour: réaliser un post-traitement sur l'enveloppe d'extension de bande passante de la trame vocale/audio courante selon au moins un paramètre parmi la classe de signal, une enveloppe d'extension de bande passante et le facteur d'inclinaison de spectre des X trames vocales/audio, afin d'obtenir une enveloppe d'extension de bande passante post-traitée de la trame vocale/audio courante.

7. Décodeur selon la revendication 6, dans lequel, en ce qui concerne la réalisation d'un post-traitement sur l'enveloppe d'extension de bande passante de la trame vocale/audio courante, l'unité de post-traitement (320) est spécifiquement configurée pour :

quand la trame vocale/audio antérieure à la trame vocale/audio courante est une trame décodée normale, et la classe de signal de la trame vocale/audio antérieure à la trame vocale/audio courante est la même que celle de la trame vocale/audio postérieure à la trame vocale/audio courante, obtenir l'enveloppe d'extension de bande passante post-traitée de la trame vocale/audio courante sur la base d'une enveloppe d'extension de bande passante de la trame vocale/audio antérieure à la trame vocale/audio courante et de l'enveloppe d'extension de bande passante de la trame vocale/audio courante ; ou

quand la classe de signal de la trame vocale/audio courante n'est pas muette, la classe de signal de la trame vocale/audio postérieure à la trame vocale/audio courante est muette et le facteur d'inclinaison de spectre de la trame vocale/audio antérieure à la trame vocale/audio courante est inférieur ou égal à un dixième seuil, modifier l'enveloppe d'extension de bande passante de la trame vocale/audio courante selon une enveloppe d'extension de bande passante ou le facteur d'inclinaison de spectre de la trame vocale/audio antérieure à la trame vocale/audio courante, afin d'obtenir l'enveloppe d'extension de bande passante post-traitée de la trame vocale/audio courante.

8. Produit de programme informatique comprenant un programme avec des instructions qui, lorsqu'elles sont exécutées par un processeur, amènent le processeur à réaliser les étapes selon l'une quelconque des revendications 1 à 4.

Acquire a speech/audio decoding parameter of a current speech/audio frame, where the foregoing current speech/audio frame is a redundant decoded frame or a speech/audio frame previous to the foregoing current speech/audio frame is a redundant decoded frame

101

Perform post processing on the speech/audio decoding parameter of the foregoing current speech/audio frame according to speech/audio parameters of X speech/audio frames, to obtain a post-processed speech/audio decoding parameter of the foregoing current speech/audio frame, where the foregoing X speech/audio frames include M speech/audio frames previous to the foregoing current speech/audio frame and/or N speech/audio frames next to the foregoing current speech/audio frame

102

Recover a speech/audio signal of the foregoing current speech/audio frame by using the post-processed speech/audio decoding parameter of the foregoing current speech/audio frame

103

FIG. 1

FIG. 2

300

Decoder

310

Parameter acquiring unit

320

Post processing unit

330

Recovery unit

FIG. 3

400

Decoder

403

Memory

402

Processor

401

FIG. 4

500

Decoder

505

501

Processor

Memory

5051

502

Operating
system

503    504

5052

User
interface

Network
interface

Application
program

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0186637 A1